**Europäisches Patentamt**

**European Patent Office**

**Office européen des brevets**

(19)

(11) Veröffentlichungsnummer : **0 373 434 B1**

(12)

# EUROPÄISCHE PATENTSCHRIFT

(45) Veröffentlichungstag der Patentschrift :
**20.05.92 Patentblatt 92/21**

(51) Int. Cl.⁵ : **H05K 5/00**, H05K 7/20

(21) Anmeldenummer : **89122172.3**

(22) Anmeldetag : **01.12.89**

(54) **Lastschaltmodul für Kraftfahrzeuge.**

(30) Priorität : **13.12.88 DE 3841893**

(43) Veröffentlichungstag der Anmeldung :
**20.06.90 Patentblatt 90/25**

(45) Bekanntmachung des Hinweises auf die
Patenterteilung :
**20.05.92 Patentblatt 92/21**

(84) Benannte Vertragsstaaten :
**BE DE ES FR GB IT SE**

(56) Entgegenhaltungen :
**DE-A- 2 552 682**
**DE-A- 3 545 253**
**FR-A- 2 328 353**
**FR-A- 2 530 396**
**US-A- 3 411 570**

(73) Patentinhaber : **Kabelwerke Reinshagen**
**GmbH**
**Reinshagenstrasse 1**
**W-5600 Wuppertal 21 (DE)**

(72) Erfinder : **Schrick, Martin, Dipl.-Ing.**
**Gronaustrasse 63**
**W-5600 Wuppertal 2 (DE)**
Erfinder : **Gerdel, Wilfried, Dipl.-Ing.**
**Am Kohlenmeiler 103**
**W-5600 Wuppertal 22 (DE)**

(74) Vertreter : **Priebisch, Rüdiger, Dipl.-Ing.,**
**Dipl.-Wirtsch.-Ing. (FH)**
**Kabelwerke Reinshagen GmbH**
**Patentabteilung Reinshagenstrasse 1**
**W-5600 Wuppertal 21 (DE)**

EP 0 373 434 B1

## Beschreibung

Die Erfindung hat sich zur Aufgabe gestellt, ein Lastschaltmodul der im Oberbegriff des Ansprüches 1 genannten Art zu entwickeln, das leichter herzustellen ist, preiswerter ist und sich durch hohe Funktionssicherheit auszeichnet, wobei die nachfolgend noch näher angeführten Zielsetzungen erreicht werden.

Em Modul gemäß dem Oberbegriff des Anspruchs 1 ist z.B aus FR-A-2328353 bekannt.

Die Lösung der Aufgabe ist durch die im Kennzeichen des Ansprüches 1 angeführten Maßnahmen erreicht, die im Hinblick auf eine Großserienfertigung ohne weiteres folgende Randbedingungen erfüllt:

Es wird eine kompakte Bauweise des Moduls erreicht bei einer Minimierung des Gewichts. Die mechanische Stabilität des Gehäuses ist groß, zumal, wenn es vorteilhaft im Druckgußverfahren aus Aluminium hergestellt wird, um eine Wärmeableitung der Verlustleistung der Power-MOSFET auch bei einer Umgebungstemperatur von ca. 85°C zu gewährleisten. Weiterhin ist das Modulgehäuse wasserdicht zu halten, wenn es an einem entsprechend gefährdeten Montageort der Karosserie sich befindet.

Aufgrund des im Kennzeichen des Ansprüches 1 angeführten Aufbaus ist in der Serienfertigung eine einfache Montage der Elektronik möglich, wobei im Reparaturfall auch die Servicefreundlichkeit im Modulaufbau hervorzuheben ist. Die Fertigung ist kostengünstig und das Modul zeichnet sich durch sehr kleine Außenmaße aus.

Durch das T-Profil der zur Montage der Power-MOSFET's dienenden Träger erhält man eine Maximierung der Kühlkörperoberfläche bei der erfindungsgemäßen Baueinheit, denn durch die geschlossene ebene Fläche der T-Balken wird für eine gute Wärmeableitung der anfallenden Verlustwärme nach außen gesorgt. Der Wärmeübergangswiderstand ist dabei sehr gering, zumal wenn man eine Wärmeleitpaste verwendet. Die Montage der Baueinheit innerhalb des Modulgehäuses kann durch einfaches Einschieben erfolgen. Für eine hohe Oberflächengüte an der von den T-Balken erzeugten ebenen Fläche ist für eine gute Auflage des Kühlkörpers an der Gehäuseinnenwand gesorgt. Innerhalb der Baueinheit ergeben sich damit sehr kleine Weglängen für die Wärmeleitung. Auf der erwähnten ebenen Oberfläche der T-Balken ergibt sich eine optimale Wärmeverteilung, wie auch eine ausreichende Wärmekapazität der als Kühlkörper fungierenden T-Träger erreicht ist. Dennoch hat diese Baueinheit ein geringes Gewicht, eine überraschend hohe mechanische Stabilität und gewährleistet eine kostengünstige Herstellung. Die Montage läßt sich auch maschinell einfach durchführen, wobei die Platine davon ungestört schnell maschinell bestückt werden kann. Der Fertigungsaufwand ist minimiert und der Aufbau der Baueinheit läßt einen universellen Einsatz zu.

Bevorzugt wird eine vertikale Montage des Modulaufbaus am Karosserieblech des Kraftfahrzeugs. Dadurch kann man die wirksame Kühlfläche bei entsprechend geringem Wärmeübergangswiderstand zwischen dem Modulgehäuse und dem Karosserieblech beliebig vergrößern. Man wird dabei zweckmäßig die Stabilität des Karosserieblechs an der Auflagefläche für das Modul durch eingestanzte Profilkanten erhöhen und damit für eine glatte Montagefläche des Modulgehäuses sorgen.

Weitere Maßnahmen und Vorteile der Erfindung ergeben sich aus den Ansprüchen und der nachfolgenden Beschreibung. Dabei erfaßt die Erfindung alle aus der Beschreibung und den nachfolgenden Zeichnungen ersichtlichen neuen Merkmale und Merkmalskombinationen, auch wenn diese nicht ausdrücklich in den Ansprüchen angeführt sein sollten. Die Zeichnungen zeigen:

Fig. 1 in schematischer Darstellung des grundsätzlichen Aufbaus einen Längsschnitt durch das an der Karosseriewand befestigte Lastschaltmodul,

Fig. 2 einen schematischen Querschnitt durch das Modul längs der Schnittlinie II-II von Fig. 1,

Fig. 3 die Draufsicht auf einen Bestandteil des bei der Erfindung verwendeten Kühlkörpers,

Fig. 4 eine Querschnittansicht durch den Bestandteil von Fig. 3 längs der Schnittlinie IV-IV und

Fig. 5 in perspektivischer Darstellung ein Teilstück eines anderen Bestandteils des Kühlkörpers.

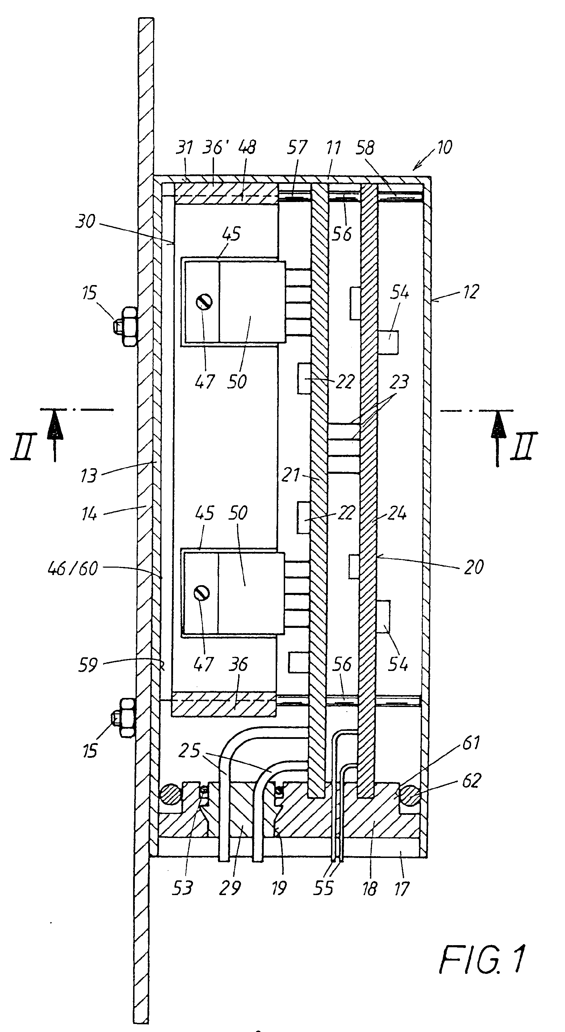

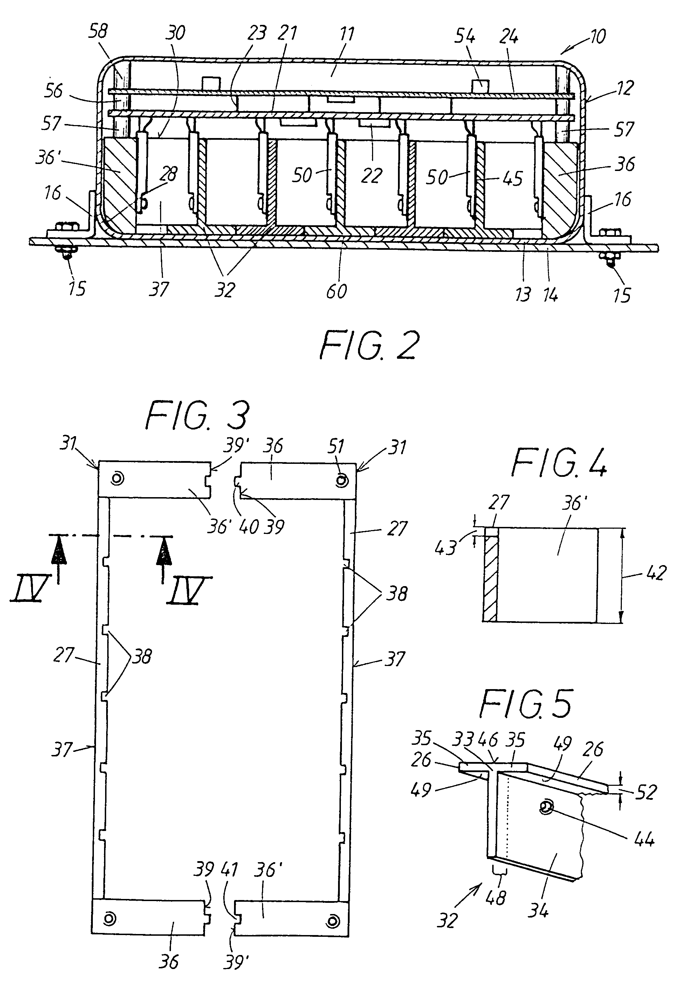

Das Lastschaltmodul besteht zunächst aus einem einseitig offenen Gehäuse 10, dessen Bodenwand 11 zwar grundsätzlich Rechteckform hat, aber mit stark gerundeten Eckbereichen. An die Bodenwand 11 schließt sich der Gehäusemantel 12 an, der an der einen Gehäuseseite in jedem Fall eine gut wärmeleitende Gehäuseaußenwand 13 besitzt, die hier eben ausgebildet ist, um an einer hier ebenfalls eben gestalteten Karosseriewand 14 durch Schraubbefestigungen 15 od. dgl. gut wärmeleitend angeschlossen zu werden. Hierzu sind, wie am besten aus Fig. 2 zu ersehen ist, am Gehäusemantel 12 mehrere Laschen 16, z.B. in Winkelform, befestigt, vorzugsweise durch Schweißen. Durch die Gehäuseöffnung 17, die im endgültigen Zustand, gemäß Fig. 1, von einem Gehäusedeckel 18 verschlossen wird, wird eine kompakte Baueinheit 20 eingeführt, die einen besonderen Aufbau hat und zu welcher zunächst in üblicher Weise eine Platine 21 gehört, die aus nachfolgend noch näher ersichtlichen Gründen mit "Lastplatine" bezeichnet werden soll. Diese Lastplatine ist in üblicher Weise natürlich mit Leiterbahnen versehen und wird mit elektronischen Bauteilen 22 bestückt, vorzugsweise in SMD-Technik, wie Widerständen, Zenerdioden. Zugleich können auch Strombrücken und Verbindungsstifte 23 für eine erst später anzusetzende weitere Platine 24 angebracht werden, die zur Unterscheidung nachfolgend als "Logikplatine 24" benannt werden soll. An der Lastplatine 21 werden dann noch Kontaktteile 25 montiert, die durch einen Deckeleinsatz 29 hindurchgeführt sind, der aber erst später in eine entsprechende Aussparung 19 des bereits erwähnten Gehäusedeckels 18 verrastend eingefügt wird.

Zu der Baueinheit 20 gehört ein besonderer Kühlkörper 30, der aus folgenden Bestandteilen zusammengesetzt ist, die ebenso wie das Gehäuse 10 aus Aluminium hergestellt sind.

Der Kühlkörper 30 besteht aus zwei unterschiedlichen Teilen, nämlich einem aus zwei U-förmigen Rahmenteilen 31 gebildeten Gesamtrahmen sowie einer Schar darin in besonderer Weise gehalterter stabförmiger Träger 32 mit T-Profil 33, das sich zusammensetzt aus einem Mittelsteg 34 und zwei T-Balken 35. Der U-förmige Rahmenteil 31 umfaßt, wie am besten aus Fig. 3 zu ersehen ist, der zwischen seinen beiden U-Schenkeln 36, 36′ einen geradlinigen Rahmensteg 37, der, in bestimmter Abstandsfolge zueinanderliegende, ins U-Innere weisende quer zum Stegverlauf angeordnete Aufnahmenuten 38 besitzt. An den Stirnflächen 39, 39′ der beiden Schenkel 36, 36′ sind zueinander komplementäre Verbindungsteile 40, 41 angeordnet, nämlich an der Stirnfläche 39 eine vorspringende Feder 40 und an der Stirnfläche 39′ eine dazu passende Nut 41.

Ein solcher Rahmenteil 31 wird im Stranggußverfahren gefertigt, und zwar mit dem aus Fig. 3 ersichtlichen Querschnittsprofil. Dieser Strang wird dann, entsprechend der aus Fig. 4 ersichtlichen Rahmenhöhe 42 in einzelne Abschnitte aufgeteilt, von denen jeweils ein Paar, in der aus Fig. 3 ersichtlichen gewendeten Position zu einem kompletten Rahmen zusammengesteckt wird. Dazu kann die eine Schmalseite 27 des Rahmenstegs 37, die im Montagezustand der Baueinheit 20 von der Lastplatine 21 weggerichtet ist, mit einer definierten Abfräsung 43 gemäß Fig. 4 versehen sein, weshalb auf dieser Seite die beiden Schenkel 36, 36′ emporragen. Die Schenkel 36, 36′ können dann auch eine aus Fig. 2 ersichtliche Kantenabrundung entsprechend der Umrißform des Gehäusemantels 12 erfahren. Der Rahmen 31 könnte alternativ auch aus hitzebeständigem Kunststoff gefertigt werden, was kostengünstiger ist. Die Hauptaufgabe des Rahmens 31 dient nämlich zur Fixierung der T-Träger 32, welche die eigentliche Aufgabe der Wärmeabführung haben, worauf noch einzugehen ist.

Die T-Träger 32 werden ebenfalls im Stranggußverfahren mit ihrem T-Profil 33 hergestellt und danach in Längenabschnitte geteilt, die dem Abstand der beiden einander gegenüberliegenden Rahmenleisten 37 im fertigen Rahmen 31 gemäß Fig 1 entsprechen, und zwar gemessen im Bereich des Nutgrundes der jeweils paarweise einander ausgerichteten Aufnahmenuten 38. Dies ergibt sich aus Fig. 1. Der T-Mittelsteg 34 des Trägers wird an definierten Stellen mit Gewindeaufnahmen 44 bzw. Nietdurchbrüchen versehen, die dazu bestimmt sind, um besondere, als Schaltelemente fungierende Smart-Power-MOSFET's wärmeleitend zu befestigen.

Dazu wird zunächst zwecks elektrischer Isolierung im Bereich der Anbringungsstelle eine wärmeleitende Therm-Folie 45 aufgeklebt, auf welche dann jeweils ein MOSFET 50 durch eine Schraube bzw. einen Niet am Träger 32 im Thermokontakt befestigt wird. Die Erfindung zeigte, daß es optimal ist, an jedem Träger 32 lediglich zwei solcher MOSFEET's 50 für die Anwendung in Kraftfahrzeugen anzubringen. Die MOSFET's könnten natürlich auch angeklebt oder alternativ durch Klammern befestigt werden. In den letztgenannten Fällen kann man dann natürlich auf die Befestigungsbohrung 44 verzichten. Die so bestückten Träger 32 werden nun mit ihren Stegenden 48, wie aus Fig. 1 zu ersehen ist, in die Aufnahmenuten 38 der Rahmenleisten 37 eingeschoben, bis schließlich die aus Fig. 5 ersichtlichen Unterseiten 49 an den abgesetzten Schmalseiten 27 der beiden Rahmenleisten 37 zur Anlage kommen. Ihre vorerwähnte Abfräsung 43 ist aber zweckmäßigerweise passend der Balkenhöhe 52 : der T-Balken 35 gestaltet, weshalb dann die Oberseiten 46 der einzelnen T-Balken 35 bündig mit den Rahmenschenkeln 36, 36′ zu liegen kommen. Die Aufnahmenuten 38 sind aber genau so gesetzt, daß im eingeführten Zustand sich benachbarte Träger 32 stets mit ihren aus Fig. 5 ersichtlichen Balkenschmalseiten 26 berühren, wie das aus dem fertigen Bauzustand von Fig. 2 deutlich zu erkennen ist. Es entsteht eine durchgehende Oberfläche 60.

Dann erfolgt zweckmäßigerweise die Montage des kompletten Kühlkörpers 30, bestehend aus den Rahmenteilen 31 und den T-Trägern 32, an der Lastplatine 21 durch Verschraubungen oder Vernietungen. Im vorliegenden Fall besitzen dazu die Rahmenschenkel 36, 36′ Gewindebohrungen 51. Ein Abstandhalter 57 an dem jeweiligen hier angreifenden Befestigungsschaft sorgt für einen kleinen Abstand zur Lastplatine 21 von ca. 5 mm, was ausreicht, um die Anschlußbeine der MOSFET's 50 an den richtigen Stellen der Platine 21 durchführen zu können. Die Kontaktteile 25 werden dann arretiert und die so vorgefertigte Logikplatine 34 einem automatischen Lötvorgang zugeführt. Dies erfolgt zweckmäßigerweise in einer Lötstraße. Danach wird die so vorgefertigte Lastplatine 21 einer elektrischen Funktionsprüfung unterzogen.

Zwischenzeitlich ist auch die andere Logikplatine 24 ebenfalls mit SMD-Bauteilen vorgefertigt worden. Nach dem Aushärten des Klebers der SMD-Bauteile erfolgt ihre Bestückung mit Verbindungsstiften 23 und Kontaktteilen 55, die durch entsprechende Durchbrüche im eingangs erwähnten Gehäusedeckel 18 durchgeführt werden. Dann wird der Gehäusedeckel vernietet und die Logikplatine 24 mit der Lastplatine 21 zu der erwähnten Baueinheit 20 montiert. Diese Baueinheit durchläuft dann eine Lötstraße, wo die Verbindungsstifte 23 bzw. weitere Jumper ihre elektrische Verbindung erfahren. Dann wird die ganze DVS-Einheit einer elektrischen Funktionsprüfung unterzogen.

Bei dem vorerwähnten Zusammenbau der Baueinheit 20 wird auf den Deckeleinsatz 29, der die oben erwähnten Versorgungsstecker 25 trägt, eine ringförmige Silicon-Dichtung 53 aufgesteckt, und diese dann in die bereits erwähnte Aussparung 19 des Gehäusedeckels 18 feuchtigkeitsdicht eingeschnappt. Die beiden Platinen 21, 24 sind auch untereinander durch Abstandhalter 56 in einem Abstand von z.B. 4 mm gesetzt, welche zweckmäßigerweise ebenfalls von der die bereits vorerwähnten Abstandhalter 57 positionierenden Schaftverbindung an den Rahmen 31 gehalten werden. Auf der nach außen gekehrten Seite der Logikplatine 21 befinden sich schließlich weitere Abstandhalter 58, welche dann über die verbleibende Resthöhe des im Gehäuse 10 anfallenden Innenraums gehen, von z.B. 7 mm. Wird nämlich die fertige Baueinheit 20 dann in das Gehäuse 10 eingeschoben, so kommt die Baueinheit in die aus Fig. 1 ersichtliche Position, wo die T-Balken-Oberseite 46 in idealem wärmeleitenden engen Kontakt mit der Innenfläche 59 der zugehörigen Gehäusewand 13 steht. Das bemerkenswerte und aus Fig. 2 Ersichtliche ist nämlich, daß sämtliche T-Träger 32 eine durchgehende, ebene Kontaktfläche 60 erzeugen, die für die Wärmeübertragung sorgt.

Im Gebrauchsfall entsteht vor allen Dingen die Verlustwärme im Bereich der MOSFET's 50, wenn man von der untergeordneten Erhitzung der Leiterbahnen absieht. Diese Verlustwärme führt zu einem Wärmestrom durch das Modulgehäuse, welches eine Wärmeemission über die Kontaktfläche 60 des erfindungsgemäßen Kühlkörpers 30 über die Gehäusewand 13 und das ganze restliche Gehäuse bewirkt. Dort tritt, in Abhängigkeit von der Montagetechnik und dem Einbauort eine Wärmekonvektion durch Luftströmung ein. Die Wärmekapazität des Gehäuses 10 ist im stationären Betrieb vernachlässigbar.

Damit ergibt sich eine Wärmeverteilung schließlich an dem bereits erwähnten Karosserieblech 14, wo ebenfalls eine Wärmeemission über die Oberfläche stattfindet. Die Wärmeabgabe erfolgt auch hier ergänzend durch Konvektion. Damit tritt eine Maximierung der Kühloberfläche auf. Beachtenswert ist die kurze Weglänge für die Wärmeleitung innerhalb des Kühlkörpers 30, und dort insbesondere an den T-Trägern 32, welche die maßgebliche Kontaktfläche 60 erstellen.

Beim Einführen der Baueinheit 20 ins Gehäuse 10 ist um den Umfang 61 des Gehäusedeckels 18 eine Silicon-Ringdichtung 62 gelegt, die im fertig eingeschobenen Zustand für eine gute Dichtigkeit gegenüber Feuchtigkeit sorgt.

Bezugszeichenliste:

| 10 | Gehäuse |
|----|---------|
| 11 | Bodenwand |
| 12 | Gehäusemantel |
| 13 | Gehäuseaußenwand |
| 14 | Karosseriewand |
| 15 | Schraubbefestigung |
| 16 | Lasche |
| 17 | Gehäuseöffnung |
| 18 | Gehäusedeckel |
| 19 | Aussparung |
| 20 | Baueinheit |
| 21 | Lastplatine |
| 22 | elektronische Bauteile |
| 23 | Verbindungsstifte, Jumper |
| 24 | Logikplatine |
| 25 | Versorgungsleitung |
| 26 | Schmalseite des T-Balkens |
| 27 | Schmalseite des Rahmenstegs |
| 28 | Kantenrundung |
| 29 | Deckeleinsatz |
| 30 | Kühlkörper |
| 31 | U-förmiger Rahmenteil |
| 32 | T-Träger |
| 33 | T-Profil |
| 34 | T-Mittelsteg |
| 35 | T-Balken |
| 36, 36′ | Balkenschenkel |
| 37 | Rahmenleiste |
| 38 | Aufnahmenut |

| 39, 39′ | Stirnfläche von 36 bzw. 36′ |
| 40 | Verbindungsteil, Feder |
| 41 | Verbindungsteil, Nut |
| 42 | Rahmenhöhe |
| 43 | Abfräsung von 42 |
| 44 | Gewindeaufnahme, Befestigungsbohrung |
| 45 | Therm-Folie |
| 46 | Oberseite von 35 |
| 47 | Schraube |
| 48 | Stegende |
| 49 | Unterseite von 35 |
| 50 | MOSFET |
| 51 | Gewindebohrung |
| 52 | Balkenhöhe |
| 53 | Silicon-Dichtung |
| 54 | elektronische Bauteile |
| 55 | Verdrahtungen |
| 56 | Abstandhalter |
| 57 | Abstandhalter |
| 58 | Abstandhalter |
| 59 | Innenfläche |
| 60 | Kontaktfläche |
| 61 | Umfang von 18 |
| 62 | Silicon-Ringdichtung |

**Patentansprüche**

1. Lastschaltmodul für Kraftfahrzeuge mit einem einseitig offenen Gehäuse (10) zur Aufnahme einer Baueinheit (20),

bestehend aus mindestens einer Platine (21) mit Leiterbahnen und mit daran angeschlossenen elektronischen Bauteilen (22),

ferner aus einem mit der Platine (21) verbundenen, die Gehäuseöffnung (17) verschließenden Gehäusedeckel (18), mit darin integrierten Kontaktteilen (25)

und schließlich aus von der Platine (21) getragenen Schaltelementen für die an den Kontaktteilen (25) angeschlossene elektrische Last,

**gekennnzeichnet durch**

eine Schar von stabförmigen Trägern (32) mit einem T-Profil (33) aus einem Mittelsteg (34) und zwei T-Balken (35),

wobei mindestens an einer Flächenseite des Mittelstegs (34) der einzelnen Träger (32) Schaltelemente in Form von Smart-Power-MOSFET's (50) zwar insbesondere elektrisch isoliert (45), aber wärmeleitend befestigt (47) sind,

und in Haltern (31,37) an der Platine (21) die einzelnen Träger (32) parallel nebeneinander liegen, mit ihren T-Balken (35) aneinanderstoßen und eine im wesentlichen geschlossene, ebene Kontaktfläche (60) erzeugen,

die im Montagefall wärmeleitend an der Innenfläche (59) der einen metallischen Außenwand (13) des Gehäuses (10) anliegt,

wobei diese Außenwand (13) an der Karosserie (14) des Kraftfahrzeugs wärmeleitend befestigt (15) ist.

2. Lastschaltmodul nach Anspruch 1, dadurch gekennzeichnet, daß die an der Platine (14) sitzenden Halter (31,37) an den Mittelstegen der T-Träger (32) angreifen.

3. Lastschaltmodul nach Anspruch 1 oder 2, dadurch gekennzeichnet, daß als Halter zwei im Abstand zueinander angeordnete Halteleisten (37) mit gegeneinander gerichteten Aufnahmenuten (38) dienen, in welche jeweils paarweise die beiden Endbereiche (48) eines Mittelstegs (34) der T-Träger (32) einschiebbar sind.

4. Lastschaltmodul nach Anspruch 3, dadurch gekennzeichnet, daß die Halteleisten (37), insbesondere abgesetzte (43) Anschlagflächen (27),zur Anlage der Unterseite (49) der T-Balken (35) der einzelnen Träger (32) aufweisen.

5. Lastschaltmodul nach einem oder mehreren der Ansprüche 2 bis 4, dadurch gekennzeichnet, daß die Halteleisten (37) Bestandteil eines an der einen Seite der Platine befestigten Rahmens (31) sind.

6. Lastschaltmodul nach einem oder mehreren der Ansprüche 3 bis 5, dadurch gekennzeichnet, daß die Halteleisten (37) bzw. der Rahmen (31) mit einer Abstandslücke (57) zur Flächenseite der Platine (21) angeordnet ist.

7. Lastschaltmodul nach Anspruch 5 oder 6, dadurch gekennzeichnet, daß der Rahmen aus zwei, vorzugsweise formgleichen Rahmenhälften (31) zusammengesetzt ist, bestehend aus U-förmig zueinander angeordneten Rahmenleisten (36,36′,37).

8. Lastschaltmodul nach Anspruch 7, dadurch gekennzeichnet, daß an den Rahmenleisten der U-Rahmenhälften (31) zueinander komplementäre Verbindungsteile (40,41), wie eine Feder-Nut-Verbindung, angeordnet sind, insbesondere an den Stirnflächen (39,39′) der Rahmenschenkel (36,36′).

9. Lastschaltmodul nach einem oder mehreren der Ansprüche 1 bis 8, dadurch gekennzeichnet, daß der T-Träger (32) der Baueinheit (20) und das die Baueinheit (20) aufnehmende Gehäuse (10) aus Aluminium bestehen.

10. Lastschaltmodul nach einem oder mehreren der Ansprüche 1 bis 9, dadurch gekennzeichnet, daß unter der die T-Träger (32) halternden Platine (Lastplatine 21) eine weitere Platine (Logikplatine 24) befestigt und mit dieser elektrisch verbunden (23) ist, wobei auf der Logikplatine (24) weitere elektronische Bauteile (54), vorzugsweise in SMD-Technik angebracht sind.

11. Lastschaltmodul nach Anspruch 10, dadurch gekennzeichnet, daß die beiden Platinen (21,24) Bestandteil der Baueinheit (20) sind und vorzugsweise deckungsgleich und in Abstand (57) zueinander liegen.

12. Lastschaltmodul nach einem oder mehreren der Ansprüche 1 bis 11, dadurch gekennzeichnet, daß das Gehäuse (10) bzw. Baueinheit (20) Anschlagteile (28,58) zur Führung der Baueinheit (20) beim Einstecken in das Gehäuse (10) und zur Positionierung der eingeführten Baueinheit (20) mit gegen ihre Innenfläche (59) angedrückten Kontaktfläche (60) der kombinierten Träger (32) aufweist.

13. Lastschaltmodul nach einem oder mehreren der Ansprüche 1 bis 12, dadurch gekennzeichnet, daß wenigstens einige der Kontaktteile (25) zu einem in eine entsprechende Aussparung (19) des Gehäusedeckels (18) einführbaren Deckeleinsatz (29) gehören.

14. Lastschaltmodul nach einem oder mehreren der Ansprüche 1 bis 13, dadurch gekennzeichnet, daß der Gehäusedeckel (18) bzw. sein Deckeleinsatz (29) an seinem ins Gehäuseinneren bzw. in der Aussparung (19) einfügbaren Umriß (61) einen umlaufenden Dichtungsring (62,53), vorzugsweise aus Silicon-Werkstoff, aufweist.

## Claims

1. Load switching module for motor vehicles, having a housing (10), which is open on one side, for receiving a structural unit (20),

comprising at least one board (21) having conductor lines and having electronic components (22) connected thereto,

further comprising a housing cover (18) which is connected to the board (21) and closes the housing opening (17), and has contact parts (25) integrated therein

and finally comprising switching elements, which are carried by the board (21), for the electrical load connected to the contact parts (25),

**characterized by**

a plurality of rod-shaped carriers (32) having a T-shaped profile (33) comprising a central web (34) and two T bars (35),

there being secured (47), specifically in an electrically insulated (45) yet heat-conducting manner, at least to one surface side of the central web (34) of the individual carriers (32), switching elements in the form of smart power MOSFETs (50),

and the individual carriers (32) lying parallel next to one another in holders (31, 37) on the board (21), abutting against one another by means of their T bars (35) and producing a substantially closed, plane contact surface (60),

which, in the case of assembly, bears in heat-conducting manner against the inner surface (59) of one metal outer wall (13) of the housing (10),

this outer wall (13) being secured (15) in heat-conducting manner to the body (14) of the motor vehicle.

2. Load switching module according to Claim 1, characterized in that the holders (31, 37) seated on the board (14) act on the central webs of the T-shaped carriers (32).

3. Load switching module according to Claim 1 or 2, characterized in that serving as the holders are two holding strips (37) arranged at a spacing from one another and having receiving grooves (38) which are directed towards one another and into which, in each case in pairs, the two end regions (48) of a central web (34) of

EP 0 373 434 B1

the T-shaped carriers (32) may be pushed.

4. Load switching module according to Claim 3, characterized in that the holding strips (37) have in particular stepped (43) stop surfaces (27) to bear against the underside (49) of the T bars (35) of the individual carriers (32).

5. Load switching module according to one or more of Claims 2 to 4, characterized in that the holding strips (37) are a constituent of a frame (31) secured to one side of the board.

6. Load switching module according to one or more of Claims 3 to 5, characterized in that the holding strips (37) or the frame (31) is arranged with a spacing gap (57) with respect to the surface side of the board (21).

7. Load switching module according to Claim 5 or 6, characterized in that the frame is composed of two preferably identically shaped frame halves (31), comprising frame strips (36, 36′, 37) arranged in a U shape with respect to one another.

8. Load switching module according to Claim 7, characterized in that there are arranged on the frame strips of the U-shaped frame halves (31) mutually complementary connection parts (40, 41), such as a tongue-and-groove connection, in particular on the end surface (39, 39′) of the frame legs (36, 36′).

9. Load switching module according to one or more of Claims 1 to 8, characterized in that the T-shaped carrier (32) of the structural unit (20) and the housing (10) receiving the structural unit (20) are of aluminium.

10. Load switching module according to one or more of Claims 1 to 9, characterized in that under the board (load board 21) holding the T-shaped carriers (32) there is secured and electrically connected (23) to said load board (21) a further board (logic board 24), there being mounted on the logic board (24) further electronic components (54), preferably by the SMD technique.

11. Load switching module according to Claim 10, characterized in that the two boards (21, 24) are a constituent of the structural unit (20) and lie preferably in congruence with and at a spacing (57) from one another.

12. Load switching module according to one or more of Claims 1 to 11, characterized in that the housing (10) or structural unit (20) has stop parts (28, 58) for guiding the structural unit (20) during insertion into the housing (10) and for positioning the inserted structural unit (20) having, pressed against the inner surface (59) thereof, a contact surface (60) of the combined carriers (32).

13. Load switching module according to one or more of Claims 1 to 12, characterized in that at least some of the contact parts (25) belong to a cover insert (29) which may be introduced into a corresponding cutout (19) of the housing cover (18).

14. Load switching module according to one or more of Claims 1 to 13, characterized in that the housing cover (18) or its cover insert (29) has on its periphery (61) which may be inserted into the housing interior or in the cutout (19) a peripheral sealing ring (62, 53), preferably of silicone material.

## Revendications

1. Module de commutation en charge pour véhicules à moteur, muni d'un carter (10) ouvert sur un côté pour le logement d'une unité modulaire (20),

constitué par au moins une platine (21) munie de glissières et de composants électroniques (22) raccordés à celles-ci,

constitué de plus par un couvercle de carter (18) raccordé avec la platine (21), obturant l'ouverture (17) du carter, avec les éléments de contact intégrés (25)

et pour finir, par des éléments de commutation montés sur la platine (21) pour la charge électrique raccordée aux éléments de contact (25),

caractérisé par

un ensemble de supports (32) en forme de barre comportant un profilé en T (33) avec une âme médiane (34) et deux poutres en T (35),

au moins sur un côté de la surface de l'âme médiane (34) des différents supports (32) des éléments de commutation sous la forme de Smart-Power-MOSFET (50) étant fixés et qui sont en particulier isolés électriquement (45) mais conducteurs thermiquement,

et dans les éléments de fixation (31, 37) sur la platine (21) les différents supports (32) étant juxtaposés parallèlement entre eux avec leurs poutres en T (35) en contact bout à bout et produisant une surface de contact (60) plane, sensiblement fermée,

laquelle dans le cas de montage vient en butée de façon à être conductrice thermiquement sur la face intérieure (59) de l'une des parois extérieures métalliques (13) du carter (10),

cette paroi extérieure (13) étant fixée de façon conductrice thermiquement sur la carrosserie (14) du véhicule à moteur.

2. Module de commutation en charge selon la revendication 1, caractérisé en ce que les éléments de fixa-

7

tion (31, 37) reposant sur la platine (14) coopèrent avec les âmes médianes des supports en T (32).

3. Module de commutation en charge selon la revendication 1 ou 2, caractérisé en ce que deux barrettes de fixation (37) agencées selon un certaine espacement entre elles avec des gorges de réception (38) en regard l'une de l'autre servent d'éléments de fixation, barrettes de fixation dans lesquelles peuvent être introduites par paires les deux régions d'extrémité (48) d'une âme médiane (34) du support en T (32).

4. Module de commutation en charge selon la revendication 3, caractérisé en ce que les barrettes de fixation (37) présentent des faces de butée (27) décalées de façon particulière (43) pour l'appui du dessous (49) des poutres en T (45) des différents supports (32).

5. Module de commutation en charge selon une ou plusieurs des revendications 2 à 4, caractérisé en ce que les barrettes de fixation (37) font partie d'un châssis (31) fixé sur un côté de la platine.

6. Module de commutation en charge selon une ou plusieurs des revendications 3 à 5, caractérisé en ce que les barrettes de fixation (37) ou le châssis (31) présentent un vide d'espacement (57) vers le flanc de la platine (21).

7. Module de commutation en charge selon la revendication 5 ou 6, caractérisé en ce que le châssis est constitué de deux moitiés de châssis (31), de préférence symétriques, constituées par des glissières de châssis (36', 37) juxtaposées en forme de U.

8. Module de commutation en charge selon la revendication 7, caractérisé en ce que, sur les glissières de châssis des moitiés de châssis en U (31), sont agencés de façon complémentaire entre eux des éléments de liaison (40, 41) tels qu'un assemblage mâle et femelle, notamment sur les faces antérieures (39, 39') des parties verticales du châssis (36,36').

9. Module de commutation en charge selon une ou plusieurs des revendications 1 à 8, caractérisé en ce que le support en T (32) de l'unité modulaire (20) et le carter 10 recevant l'unité modulaire (20) sont en aluminium.

10. Module de commutation en charge selon une ou plusieurs des revendications 1 à 9, caractérisé en ce que sous la platine de montage des supports en T (32) (platine de charge 21) est fixée une platine supplémentaire (platine de logique 24) et qui est reliée avec celle-ci électriquement (23), des composants électroniques (54) supplémentaires de préférence selon la technologie SMD étant disposé sur la platine de logique (24).

11. Module de commutation en charge selon la revendication 10, caractérisé en ce que les deux platines (21, 24) font partie de l'unité modulaire (20) et reposent de préférence en coïncidence et selon un certain espacement (57).

12. Module de commutation en charge selon une ou plusieurs des revendications 1 à 11, caractérisé en ce que le carter (10) ou l'unité modulaire (20) présentent des éléments de butée (28, 58) pour le guidage de l'unité modulaire (20) lors de leur insertion dans le carter (10) et pour le positionnement de l'unité modulaire introduite (20) et des surfaces de contact (60) des supports combinés (32) appuyés contre leur face intérieure (59).

13. Module de commutation en charge selon une ou plusieurs des revendications 1 à 12, caractérisé en ce qu'au moins certains des éléments de contact (25) font partie d'un ensemble couvercle (29) insérable dans un évidement correspondant (19) du couvercle de carter (18).

14. Module de commutation en charge selon une ou plusieurs des revendications 1 à 13, caractérisé en ce que le couvercle de carter (18) ou l'ensemble couvercle (29) présente sur sa périphérie (61) insérable dans l'intérieur du carter ou dans l'évidement (19) une bague d'étanchéité circulaire (62, 53), de préférence en silicone.

FIG.1

FIG. 2

FIG. 3

FIG. 4

FIG. 5